# EUROPEAN PATENT APPLICATION

(11) **EP 4 648 068 A1**
(43) Date of publication of application: **12.11.2025**
(21) Application number: 24174825.0
(22) Date of filing: 08.05.2024
(51) Int. Cl.: H01F 6/00, H02H 7/00, G01R 33/3815, H01F 6/04

(54) **MEANS FOR RAMPING DOWN A SUPERCONDUCTING MAGNET**

(71) Applicant: Siemens Healthineers AG, 91301 Forchheim (DE)
(72) Inventor: POPESCU, Stefan, 91056 Erlangen (DE)
(74) Representative: Siemens Healthineers Patent Attorneys

(57) **Abstract**

The invention relates to a magnet arrangement (11) for a magnetic resonance device (10), comprising a superconducting magnet (12; 29), a conversion unit (30), and a switch (31), wherein the switch (31) is configured to interrupt a closed-circuit current in the superconducting magnet (12; 29) and divert electrical energy accumulated in the superconducting magnet (12; 29) to the conversion unit (30), and wherein the conversion unit (30) is configured to convert the electrical energy accumulated in the superconducting magnet (12; 29) to mechanical energy and to store the mechanical energy for a predetermined period of time. The invention further relates to a magnetic resonance device (10) comprising an inventive magnet arrangement (11).

## Description

Independent of the grammatical term usage, individuals with male, female or other gender identities are included within the term.

The costs for cryogenic fluids (e. g. helium, neon, argon, etc.) used in superconducting magnets for magnetic resonance devices have been rising for years. The supply of cryogenic fluids to customer sites is energy intensive and associated with significant losses, as all cryogenic fluids easily escape into the earth's atmosphere and are lost forever. Therefore, the consideration of new designs for magnetic resonance devices requiring only a low volume of cryogenic fluid for cooling the superconducting magnets has gained a large commercial momentum. The so called "low helium inventory magnets" require only a low volume of cryogenic fluids which allows for a reduction of costs associated with filling and refilling the cryogenic fluids when servicing or maintaining the magnetic resonance device. A new generation of superconducting magnets, also known as "dry" magnets or "sealed-for-life" magnets, do not even require a refilling during the whole operational life.

The use of dry magnets may be instrumental in reducing the costs associated with the operation of magnetic resonance devices, as well as enabling the installation of new magnetic resonance devices at remote locations where the supply of cryogenic fluids is difficult and/or associated with high maintenance costs. However, decreasing the volumes of cryogenic fluids in magnet resonance devices also decreases the thermal capacity of the "cold mass" and thus, increases susceptibility to unintended ramp-downs of the superconducting magnet in fault conditions, such as intermittent interruptions in the supply of electrical energy (e. g. due to blackouts or power failures) or cooling water. In such emergency situations the superconducting magnet is ramped down (or rundown) automatically in a controlled way to prevent an aggressive and potentially damaging magnet quench. Subsequently, in the absence of active cooling, the cold mass of the superconducting magnet begins to warm up. This in turn significantly reduces the availability or uptime of the magnetic resonance device due to the long times typically required to cool the magnet down to the operational cryogenic temperatures. These limitations pose a challenge to the operation of new magnetic resonance devices comprising dry magnets and may prevent their commercial success.

In conventional or "wet" magnetic resonance devices, ramping down a superconducting magnet requires connecting a (portable) magnet power supply across dedicated terminals of the superconducting magnet and opening a superconducting switch (e. g. a thermal switch within the magnet circuitry) to divert an electric current within the superconducting magnet to flow through the magnet power supply. Typically, a high-power diode arrangement is provided within the magnet power supply, which causes a constant voltage-drop in the electric current path of the superconducting magnet. This voltage drop, in combination with the current flowing through it, leads to a conversion of electrical energy to heat energy. This heat energy is typically transferred from the diode arrangement to a heat sink provided within the magnet power supply. As the heat sink is heated, it releases the heat energy to the ambient, mainly by thermal convection, but also by thermal radiation and thermal conduction. A heat transfer area of the heat sink must be large to release the heat energy at a rate similar to the rate of conversion of electrical energy to heat energy by the diode arrangement.

This conventional solution requires a large and heavy arrangement of diode and heat sink to avoid overheating when dissipating the electrical energy stored in the superconducting magnet (the energy stored in a superconducting magnet is magnetic energy, but for convenience will hereinafter be referred to as electrical energy or accumulated electrical energy). In a typical 1.5 T magnetic resonance device, the superconducting magnet may store about 4 MJ of energy within the inductivity of its superconducting coils. The magnet power supply may be designed to dissipate this energy in about 30 minutes. This represents an average dissipation power of 2.2 kW, but peak powers may be much higher. The dissipation of electrical energy from a 3 T magnetic resonance device may take three times as long, using the same arrangement of diode and heat sink (also known as "run-down load"). In some magnet power supplies, the diode may be replaced by a resistor.

In more modern "dry" magnetic resonance devices, the magnet power supply is usually stationary and permanently attached to a mechanical frame or support structure of the superconducting magnet. The magnet power supply is used for ramping down the superconducting magnet in emergency situations, but also for ramping up the superconducting magnet after any intermittent failure. Magnet power supplies are considered robust, reliable, and relatively cheap, but there are many disadvantages associated with this prior art solution.

As the electric energy stored by the superconducting magnet increases with the magnetic field strength, the requirements regarding both peak power dissipation and total power dissipation of the run-down load also increase. These requirements increase exponentially for 3 T magnetic resonance devices and even more for 7 T magnetic resonance devices. As a consequence, a size and mounting space for the magnet power supply increases, but also the size, the weight and the footprint of the magnetic resonance device.

Another consequence is that the amount of heat energy released to the ambient by the magnet power supply exponentially increases with higher magnetic field strengths, thus increasing the ambient temperature in an enclosure or examination room comprising the magnetic resonance device and necessitating higher cooling capacities of cooling equipment configured to cool the examination room. This is even more challenging during power failures and/or a failure of the cooling equipment.

A further consequence is that a total time needed to ramp down a dry high-field magnetic resonance device (e. g. above 1.5 T) may significantly increase beyond 30 minutes. To avoid overheating the heatsink, the peak power dissipated by the magnet power supply and the peak temperature of the heatsink must be controlled by limiting the decay rate of the electrical current in the superconducting magnet, which in turn prolongs the time necessary to ramp down a dry magnetic resonance device.

Finally, and probably the most significant disadvantage of run-down loads according to the prior art is of conceptual nature. As described above, a dry superconducting magnet is ramped down automatically in the event of an interruption of the electrical energy supply and/or cooling. In such emergency cases, superconducting magnet in dry magnetic resonance devices warm up much faster than superconducting magnets in conventional wet magnetic resonance devices. This is due to the low thermal capacity provided by the cryogenic fluid in dry magnetic resonance devices, which may amount to less than a few liters of liquid helium as compared to several hundred liters of liquid helium available in wet magnetic resonance devices. A cool-down time of the cold mass of a magnetic resonance device directly depends on a peak temperature the cold mass reaches after the superconducting magnet has been ramped down. As this cool-down may take several days or even several weeks, any measure preventing the cold mass from warming up in an emergency condition reduces a down time of the magnetic resonance device (i. e. a period during which the magnetic resonance device is unavailable or inoperative). Given this consideration, converting the electrical energy in the superconducting magnet into heat energy and releasing this heat energy within a housing of the magnetic resonance device or in close proximity to the housing of the magnetic resonance device may significantly increase the down time after an emergency ramp-down. This is because at least a share of the heat energy dissipated to the ambient is transported to the cold mass of the magnetic resonance device, mainly by thermal convection, but also by thermal radiation and thermal conduction, thus unnecessarily increasing its temperature when cooling is inactive.

Many prior art methods discharge the energy stored in the superconducting magnet at variable current decay rates and changing output voltage, which is inconvenient for re-use of the electrical energy.

It is an object of the invention to prevent or reduce heating of a cold mass of a magnetic resonance device after a ramp down.

This object is achieved by a magnet arrangement and a magnetic resonance device according to the invention. Further advantageous embodiments are specified in the dependent claims.

The inventive magnet arrangement is configured for use in a magnetic resonance device. The magnet arrangement comprises a superconducting magnet, a conversion unit, and a switch.

The magnet arrangement may comprise a main magnet or one or more superconducting magnets forming a main magnet. Each superconducting magnet may comprise or consist of a superconducting coil. In a preferred embodiment, the magnet arrangement comprises at least two solenoidal or cylindrical superconducting coils. The at least two solenoidal or cylindrical superconducting coils may be rotationally symmetric or comprise rotationally symmetric bodies. The at least two superconducting coils may define a common axis. Preferably, the common axis defined by the at least two superconducting coils corresponds to a cylinder axis and/or an axis of rotational symmetry of the main magnet and/or the one or more superconducting magnets.

According to an embodiment, the magnet arrangement comprises at least two superconducting magnets. The at least two superconducting magnets may be mechanically coupled and/or mechanically connected. Preferably, the at least two superconducting magnets form a cohesive or coherent structure.

The magnet arrangement may comprise a magnet support structure configured to provide mechanical support to the one or more superconducting magnets. Particularly, the magnet support structure may be configured to maintain a predefined spatial arrangement of at least two superconducting magnets. According to an embodiment, the magnet support structure is configured to be mechanically connected to a support structure, particularly an outer vacuum chamber, of a magnetic resonance device. It is also conceivable that at least two superconducting magnets of the magnet arrangement are integrally bonded. Particularly, the at least two superconducting magnets may be integrally bonded to at least one spacer arranged between the at least two superconducting magnets.

The conversion unit may be configured to convert one form of energy into another form of energy. For example, the conversion unit may be configured to convert electrical energy into mechanical energy, particularly kinetic energy or potential energy. In a preferred embodiment, the conversion unit comprises an electro-mechanical converter configured to convert electrical energy into mechanical energy. The conversion unit may also comprise an electro-mechanical storage device configured to convert electrical energy into mechanical energy and to store the mechanical energy. The electro-mechanical storage device may comprise an electro-mechanical converter.

For example, the conversion unit may be configured to use the electrical energy accumulated in the superconducting magnet to compress a gas or a spring. The mechanical energy stored in the compressed gas or spring may be used to move a patient table, a patient positioning device and/or another component of a magnetic resonance device comprising the magnet arrangement.

According to a preferred embodiment of the inventive magnet arrangement, the conversion unit is configured to convert the stored mechanical energy to electrical energy. Particularly, the electro-mechanical storage device may be configured to convert the stored mechanical energy to electrical energy. For example, the electro-mechanical storage device may comprise a generator configured to convert kinetic energy and/or potential energy into electrical energy. A generator may be configured to convert motion-based power (e. g. potential and/or kinetic energy) into electric power for use in an external electric circuit or an external power grid. The generator may comprise, for example, a dynamo or an alternator.

A conversion unit configured to convert the stored mechanical energy into electrical energy may favourably allow for storing and re-using the electrical energy accumulated in the superconducting magnet. Furthermore, an inventive magnet arrangement may allow for an extraction of electrical energy from the superconducting magnet during a ramp-down process, but also a re-use of the extracted energy, e. g. to power electrical devices and/or a cooling system configured to cool the superconducting magnet and/or other components of the magnetic resonance comprising the magnet arrangement. Thus, energy may favourably be used more efficiently and heating of the superconducting magnet during a power failure or an interruption in energy supply may be reduced or minimized.

The conversion unit may further comprise one or more conditioning units, such as an inverter, a controlled rectifier, and/or a converter, configured to condition a property of electrical energy supplied to the electro-mechanical converter and/or electro-mechanical storage device. The conditioning unit may also be configured to condition a property of energy released from the electro-mechanical storage device. For example, the conditioning unit may be configured to condition a property of the electrical energy released from the electro-mechanical storage device taking into account a requirement of a connected power grid.

The magnet arrangement may comprise a suitable electrical circuit or electrical network electrically connecting the superconducting magnet and the conversion unit, particularly the superconducting magnet, the electro-mechanical storage device, the one or more conditioning units and/or the connected power grid.

The switch may be configured to electrically connect the superconducting magnet to the conversion unit. Particularly, the switch may represent a superconducting switch comprising a superconducting element or superconducting link electrically connected to the superconducting magnet. The switch may be configured to be manually controlled and/or automatically controlled.

According to an embodiment, the switch is configured to electrically connect the superconducting magnet to the conversion unit in response to a control signal provided by a control unit. However, the switch may also be configured to provide an electrical connection between the superconducting magnet and the conversion unit in response to a temperature of a section of an electrical circuit of the superconducting magnet and/or the switch exceeding a threshold value. For example, the superconducting element of the switch may be configured to maintain a closed-circuit current in the superconducting magnet when cooled below a superconducting temperature. The superconducting element of the switch may also be configured to interrupt a closed-circuit current in the superconducting magnet when the temperature of the superconducting element exceeds the superconducting temperature of the superconducting element. Preferably, the switch comprises a heater configured to heat the superconducting element in response to a control signal.

In some embodiments, an activation mechanism of the switch comprises or consists of a thermosyphon, a heat pipe, a gas gap, but also a solenoidal (e. g. a magneto-resistive) or mechanical switch.

According to the invention, the switch is configured to interrupt a closed-circuit current in the superconducting magnet and divert electrical energy accumulated in the superconducting magnet to the conversion unit. The conversion unit is configured to convert the electrical energy accumulated in the superconducting magnet to mechanical energy and to store the mechanical energy for a predetermined period of time.

In a preferred embodiment, the switch is configured to electrically connect the superconducting magnet to the conversion unit, while interrupting the closed-circuit current in the superconducting magnet. Thus, the electrical energy may be transferred from the superconducting magnet to the conversion unit and stored within an electro-mechanical storage device in accordance with an embodiment described herein.

An inventive magnet arrangement may prevent or reduce a conversion of electrical energy accumulated within a superconducting magnet into heat energy when ramping down the superconducting magnet. Thus, a release of thermal energy and an associated heating of a cold mass of a magnetic resonance device comprising the magnet arrangement may favourably be inhibited. Particularly, the inventive magnet arrangement may favourably prevent a heating of the cold mass by thermal energy released from a conventional run-down load during a magnet ramp-down.

According to an embodiment of the inventive magnet arrangement, the conversion unit is electrically connected to a cooling system.

The cooling system may represent a water chiller, an air conditioning system, or any refrigeration system configured to cool a specific part or component of a magnetic resonance device comprising the magnet arrangement, such as a gradient system and/or a radio-frequency system, but also an examination room comprising the magnetic resonance device.

The cooling system may also comprise a cryocooler configured to cool the superconducting magnet. Particularly, the cryocooler may be configured to cool the cold mass of the magnetic resonance imaging device comprising the magnet arrangement. For example, the cryocooler may be configured to cool the superconducting magnet, a main magnet, a magnet support structure, a thermal shield, a thermal buffer and/or a cryogen vessel of a magnetic resonance device comprising the magnet arrangement. In a preferred embodiment, the cryocooler is configured to cool the cold mass to a temperature below a superconducting temperature of the superconducting magnet. The cryocooler may comprise a cold head with one or more stages with different temperature levels. For example, the cryocooler may be implemented as a pulse tube refrigerator, a Gifford-McMahon refrigerator, a Stirling cryocooler, a Joule-Thomson cooler, or the like.

The conversion unit may be configured to power the cooling system using the stored mechanical energy.

For example, the electro-mechanical storage device may be electrically connected to the cooling system. Particularly, the electro-mechanical storage device may be configured to directly power the cooling system. It is also conceivable that the electro-mechanical storage device is electrically connected to the cooling system via a conditioning unit configured to condition a property of the electrical energy provided by the electro-mechanical storage device in accordance with a requirement of the cooling system.

In converting the stored mechanical energy into electrical energy and powering a cooling system configured to cool one or more parts of a magnetic resonance device comprising the magnet arrangement, a heating of the cold mass of the magnetic resonance device may favourably be slowed down as much as possible, ideally until the power failure or interruption of power supply is resolved.

According to an embodiment of the inventive magnet arrangement, the conversion unit comprises an electro-mechanical storage device configured to absorb and store the electrical energy from the superconducting magnet in form of mechanical energy. The electro-mechanical storage device is also configured to convert the mechanical energy into electrical energy and release the electrical energy on demand.

The electro-mechanical storage device may be configured in accordance with an embodiment described above. According to an embodiment, the electro-mechanical storage device may be configured to absorb and store electrical energies accumulated in the superconducting magnet from one or more ramp-downs of the superconducting magnet. Particularly, the electro-mechanical storage device may be configured to convert the stored mechanical energy from one or more ramp-downs of the superconducting magnet into electrical energy and provide the electrical energy to a cooling system and/or an electrical grid or power grid in accordance with an embodiment described above.

The electro-mechanical storage device may also be configured to convert the stored mechanical energy into electrical energy and provide the electrical energy to a cooling system and/or a power grid in response to a control signal provided by a control unit.

Furthermore, the electro-mechanical storage device may be configured to convert the stored mechanical energy into electrical energy and provide the electrical energy to a cooling system operating at a partial load or in an emergency mode according to an embodiment described below.

An electro-mechanical storage device configured to convert the mechanical energy to electrical energy and release the electrical energy on demand may favourably allow for a storage of electrical energy from multiple ramp-downs. Furthermore, the inventive magnet arrangement may favourably allow for electrical energy from the superconducting magnet to be efficiently re-used to power a cooling system, a component of a magnetic resonance device comprising the magnet arrangement and/or a power grid. Particularly, an electro-mechanical storage device configured to convert stored mechanical energy into electrical energy and release the electrical energy on demand may favourably be used to power a cooling system operating at partial load or in an emergency mode, but also a separate emergency cooling system.

According to an embodiment of the inventive magnet arrangement, the electro-mechanical storage device comprises at least one of a flywheel, a gravity battery, or a compressed-air storage.

A flywheel energy storage (hereinafter flywheel) comprises a rotor suspended by (magnetic) bearings, which can be accelerated to high speeds. The moving or rotating rotor stores mechanical energy as kinetic energy. To increase the kinetic energy stored in the flywheel, the rotational speed of the rotor may be increased, e. g. by accelerating the rotor via a motor supplied with the electrical energy accumulated within the superconducting magnet. The rotor can be coupled with a generator configured to convert the kinetic energy of the rotor into electrical energy. As a consequence of the law of conservation of energy, extracting stored energy from the flywheel reduces the flywheel's rotational speed.

In the following, the term motor/generator is used to refer to the motor and/or the generator, which may represent separate components or form an integrated unit. Preferably, the rotor and the motor/generator are enclosed in a vacuum enclosure to reduce friction and other forms of energy loss. When electric energy is supplied to the flywheel, the motor/generator may act as an electromotor accelerating the rotational speed of the rotor. To extract energy from the flywheel, the rotor may drive the motor/generator which then supplies electric energy to a connected cooling system, utility network or other power grid according to an embodiment described above.

The rotor may comprise or consist of a high strength carbon-fibre composite. Preferably, the rotor is configured to spin at 20,000 to over 50,000 rpm in the vacuum enclosure of the flywheel. Particularly, the rotor may be configured to be accelerated up to nominal speed in a matter of seconds or minutes and reach a maximum energy capacity more quickly in comparison to other types of (electrical) energy storage devices.

A flywheel may favourably overcome disadvantages of other types of energy storage devices (e. g. electrical energy storage, electric batteries, conventional capacitors, etc.), such as low capacity, long recharging times, heavy weight, and/or short expected lifetimes. Furthermore, a flywheel may favourably be used to power and stabilize isolated utility energy networks (electrical islands) and electrical utility networks within existing power grids.

A compressed-air energy storage may be configured to convert the electric energy accumulated in the superconducting magnets into a form of potential energy by compressing air into a high-pressure air tank. The compressed-air energy storage may comprise an electrically powered compressor or turbo-compressor configured to compress air using the electrical energy discharged from the superconducting magnet. The compressed-air energy storage may further comprise a turbine, a turbo-expander, or a compressed-air engine driving an electrical generator which converts the stored potential energy into electrical energy.

In using a compressed-air energy storage, fast-moving parts storing mechanical energy may be avoided. Thus, a risk of failure and/or an increased maintenance effort associated with fast-moving parts may favourably be reduced.

A gravity battery may comprise a weight configured to store potential energy. The gravity battery may be configured to convert the electrical energy accumulated in the superconducting magnet into potential energy by lifting the weight to a certain height using, for example, a pump, a crane, a motor, or the like. The lifted weight may store a certain amount of potential energy based on a mass and a lifting height of the weight. To extract stored energy from the gravity battery, the weight may be lowered, and its potential energy converted into electrical energy via a generator.

According to an embodiment, the weight of the gravity battery may comprise a block of dense material, such as metal, stone, and/or concrete. However, the weight may also comprise or consist of a volume of a liquid configured to be pumped from a lower reservoir to a higher reservoir. In a preferred embodiment, the gravity battery is configured to pump water from the lower reservoir to the higher reservoir to convert the electrical energy accumulated in the superconducting magnet into potential energy. The gravity battery may be configured to extract the stored energy by releasing water from the higher reservoir to the lower reservoir and passing the water through a turbine.

A gravity battery may provide a particularly robust and/or cost-effective solution for an electro-mechanical energy storage device in places providing enough space to accommodate the gravity battery.

The inventive magnet arrangement may comprise a plurality of electro-mechanical energy storage devices. For example, the magnet arrangement may comprise one or more flywheels, one or more high-pressure air tanks, one or more gravity batteries, or any combination of one or more electro-mechanical energy storage devices according to an embodiment described above.

According to an embodiment of the inventive magnet arrangement, the conversion unit comprises a conditioning unit configured to discharge the electrical energy accumulated in the superconducting magnet at a substantially constant current decay rate and to provide electrical energy to the electro-mechanical storage device at a predetermined voltage.

The conditioning unit may be implemented in accordance with an embodiment of a conditioning unit described above. In a preferred embodiment, the conditioning unit comprises or consists of an inverter. The conditioning unit may be electrically arranged between the superconducting magnet and the electro-mechanical energy storage device. Particularly, an input of the conditioning unit may be electrically connected to the superconducting magnet and an output of the conditioning unit may be electrically connected to the electro-mechanical storage device.

According to an embodiment, an electrical topology of the conditioning unit is configured in such a way to allow for the conditioning unit to receive the electrical energy accumulated in the superconducting magnet at a substantially constant voltage and a substantially constant current decay rate.

A conditioning unit may comprise an inverter, a controlled rectifier and/or a converter known from the prior art.

In a preferred embodiment, the conditioning unit comprises an inverter. The inverter may be arranged electrically between the superconducting magnet and the electro-mechanical storage device. The conversion unit may be configured to discharge the electrical energy accumulated in the superconducting magnet through or via the inverter. For example, the inverter may comprise an input configured to receive electrical energy from an output of the superconducting magnet. The inverter may be configured to maintain a substantially constant voltage at the input of the inverter by controlling a phase relationship between voltage and current at an output of the inverter. The output of the inverter may be electrically connected to the electro-mechanical storage device. The inverter may also be configured to operate in an overload mode during constant voltage discharge. Operating the inverter in the overload mode may favourably decrease a magnet discharging time.

An inventive magnet arrangement comprising a conditioning unit may allow for a shorter ramp-down time of the superconducting magnet in comparison to prior art methods that rely on a constant resistive discharge or constant power discharge. Particularly, discharging the magnet at a substantially constant voltage may favourably reduce the magnet discharging time (relative to a discharge with constant power or constant resistance). Thus, a risk and/or an extent of damage to the superconducting magnet during an unscheduled ramp-down can favourably be reduced.

In a further embodiment of the inventive magnet arrangement, the conversion unit comprises a further conditioning unit electrically connected to a power grid and configured to condition a property of the electrical energy provided by the electro-mechanical storage device in dependence of a requirement of the power grid.

The further conditioning unit may be configured in accordance with an embodiment of a conditioning unit described above. In a preferred embodiment, the further conditioning unit comprises or consists of an inverter.

An electrical topology of the further conditioning unit may be configured in such a way to allow for a conditioning of electrical energy provided by the electro-mechanical storage device in dependence of a requirement of the power grid. Particularly, the further conditioning unit may be configured to provide electrical energy having a predetermined voltage, a predetermined frequency and/or a predetermined current (e. g. an alternating current at 230 V and 50 Hz). For example, the further conditioning unit may be configured to extract energy from the electro-mechanical storage device and provide this energy in an appropriate form to a limited number of parts or energy consumers of a magnetic resonance device comprising the magnet arrangement.

An inventive magnet arrangement comprising a further conditioning unit may favourably allow for the electrical energy extracted from the electro-mechanical storage device to be used in power grids, electrical utility networks and/or electrical island networks having special requirements regarding network quality. For example, a compressor providing a compressed cryogenic fluid to a cryocooler according to an embodiment described above may have specific requirements regarding the frequency and/or voltage of the electrical energy supplied by the conversion unit. Such requirements may favourably be met using a further conditioning unit according to the invention.

According to an embodiment, the power grid represents an electrical utility network providing power to the magnet arrangement and/or a cooling system cooling the magnet arrangement, or an electrical island electrically insulated from the electrical utility network at least during a ramp-down of the superconducting magnet.

Preferably, the electrical island comprises only components or devices involved with the cooling of a cold mass of a magnetic resonance device comprising the magnet arrangement. In one example, the electrical island may represent a part of a larger electrical network or power grid which can be electrically separated or insulated from the electrical network or power grid and supplied with electrical energy provided by the conversion unit. The electrical island may comprise at least one component, particularly a cooling system, configured to operate at a partial load or in an emergency mode according to an embodiment described below.

Electrically connecting the conversion unit to an electrical island comprising a cooling system configured to cool a cold mass of a magnetic resonance device comprising the inventive magnet arrangement may favourably ensure a cooling of the cold mass, but also a safe discharge of electrical energy accumulated in the superconducting magnet, irrespective of a power failures or other interruptions or errors in the power supply.

According to an embodiment, the inventive magnet arrangement comprises an electrical energy storage electrically connected to the conversion unit.

Preferably, the electrical energy storage is configured to store the electrical energy accumulated in the superconducting magnet and/or the electrical energy provided by the electro-mechanical storage device.

In a preferred embodiment, the electrical energy storage comprises or consists of one or more electric batteries and/or supercapacitors. Preferably, a charging time of the electrical energy storage may amount to a few milliseconds, a few hundred milliseconds, or a few seconds (e. g. in case the electrical energy storage is a supercapacitor).

According to a further embodiment, the electrical energy storage is configured to store electrical energy from a plurality of ramp-downs (e. g. in case the electrical energy storage is an electric battery). For example, a maximum storage capacity of the electrical energy storage may exceed an amount of electrical energy accumulated in the superconducting magnet or a multiple of the amount of electrical energy accumulated in the superconducting magnet. Thus, electrical energy from a plurality of ramp-downs can be stored and used as backup energy.

According to a further embodiment, the conversion unit may be configured to pre-charge the electrical energy storage using electrical energy from a main grid to stretch or expand the amount of electrical energy available during a power failure or an interruption in energy supply. Thus, a maximum operating period of a cooling system using the electrical energy from the conversion unit may favourably be extended.

The electrical energy storage may be configured to receive electrical energy from the superconducting magnet and supply electrical energy to the electro-mechanical energy storage device, which converts the electrical energy into mechanical energy in accordance with an embodiment described above. However, the electrical energy storage may also be configured to receive and store electrical energy supplied by the electro-mechanical energy storage device and provide the electrical energy to a connected cooling system, a utility network, and/or a power grid on demand.

An electrical energy storage may favourably stabilize a supply of electrical energy to the electro-mechanical storage device, but also to a connected cooling system, utility network, or electrical island.

The inventive magnetic resonance device is configured to perform a magnetic resonance measurement of an object positioned within an imaging region of the magnetic resonance device. The magnetic resonance device comprises a magnet arrangement according to an embodiment described above.

Preferably, the magnetic resonance device is configured to acquire magnetic resonance image data, particularly diagnostic magnetic resonance image data, from the object positioned within the imaging region. The object may be an inanimate object or a patient, particularly a human or an animal.

The inventive magnetic resonance device may represent a closed bore scanner. A closed bore scanner may comprise a substantially cylindrical bore circumferentially enclosing the imaging region. The magnet arrangement of the closed bore scanner may comprise one or more solenoidal superconducting magnets or superconducting coils circumferentially encompassing the imaging region along an axial direction or an axis of rotational symmetry of the cylindrical bore. The one or more superconducting magnets may comprise a superconducting wire having a negligible electrical resistance at (or below) a superconducting temperature. A direction of a main magnetic field provided via the one or more superconducting magnets may be oriented substantially in parallel to a direction of access of the object to the imaging region and/or the axial direction of the cylindrical bore. However, the inventive magnetic resonance device may also represent an open bore scanner, a C-type scanner, a dipolar scanner, a single-sided scanner, or the like.

The inventive magnetic resonance device may comprise further components required for a proper operation of the magnetic resonance device. For example, the magnetic resonance device may comprise an outer vacuum chamber, a magnet support structure, a thermal shield, a cryocooler, a cryogen vessel, and the like. Components of the magnetic resonance device maintained at a superconducting temperature of the superconducting magnet may be summarized or subsumed under the term cold mass. For example, the superconducting magnet, the magnet support structure, but also the thermal shield and/or a cryogen vessel may form a part of the cold mass of the magnetic resonance device.

According to an embodiment, the magnetic resonance device comprises an outer vacuum chamber enclosing the superconducting magnet. The outer vacuum chamber may be formed as a double-walled hollow cylinder comprising an outer shell and an inner shell connected by annular end pieces. The superconducting magnet may be enclosed between the outer shell and the inner shell of the outer vacuum chamber. The inner shell of the outer vacuum chamber may correspond to a patient bore of the magnetic resonance device.

In some embodiments, the magnetic resonance device may comprise one or more cryogen vessels. A cryogen vessel may be configured for storing and/or preserving a fluid, particularly a cryogen, at a predefined temperature level. Preferably, the fluid or cryogen exhibits a low boiling point. Examples of suitable fluids or cryogens are Argon, Nitrogen, Neon, Helium, and the like. The predefined temperature level may substantially correspond to a superconducting temperature of the main magnet.

A cryocooler may be configured in accordance with an embodiment described above. The cryocooler may be configured to cool the one or more superconducting magnets of the magnet arrangement and/or maintain the one or more superconducting magnets at a temperature level close to the superconducting temperature. The magnet arrangement, the thermal shield, the magnet support structure, and/or the cryogen vessel may be thermally connected to the cryocooler via a solid thermal conductor, a convection loop and/or a heat pipe.

In a preferred embodiment, the inventive magnetic resonance device represents a "dry" magnetic resonance device comprising a minimum of cryogen or no cryogen at all. For example, the inventive magnetic resonance device may comprise one or more small cryogen vessels thermally connected to the main magnet via a solid thermal conductor. The one or more small cryogen vessels may each contain a volume of less than 10 I, less than 5 I, or preferably less than 1 I of cryogen. According to an embodiment of the inventive magnetic resonance device, a cryogen vessel is omitted, and the magnet arrangement is cooled entirely via thermal conduction.

The magnetic resonance device shares the advantages of the inventive magnet arrangement according to an embodiment described above.

According to an embodiment, the inventive magnetic resonance device comprises a control unit and an uninterruptible power supply. The control unit is electrically connected to the uninterruptible power supply. The control unit is configured to initiate a controlled ramp-down of the magnetic resonance device and control the switch to interrupt the closed-circuit current in the superconducting magnet and divert electrical energy accumulated in the superconducting magnet to the conversion unit.

The control unit may represent a main control unit of the magnetic resonance device or form a part of a main control unit of the magnetic resonance device. However, the control unit may also be implemented as a stand-alone device. The control unit may comprise a signal connection connecting the control unit and the main control unit of the magnetic resonance device.

The uninterruptible power supply may comprise or consist of one or more electric batteries and/or emergency power generators (e. g. a Diesel generator, a cogeneration unit, a fuel cell, and the like). Preferably, the uninterruptible power supply is configured to maintain or take over the electrical energy supply of the control unit, but also components of the magnetic resonance device, in the event of a power failure or other interruption of the electric power supply. The uninterruptible power supply may be configured to supply the control unit, but also components of the magnetic resonance device, with electrical energy for a period of several seconds, several minutes, or several hours.

An inventive magnetic resonance device comprising a control unit and an uninterruptible power supply may favourably prevent a superconducting magnet from quenching in the event of a power failure, but also a manual shut down initiated by a user. Furthermore, the inventive magnetic resonance device may favourably allow for the electrical energy accumulated in the superconducting magnet to be diverted to or stored in the conversion unit, thus preventing electrical energy to be converted to heat energy potentially heating the cold mass of the magnetic resonance device.

According to a preferred embodiment, the inventive magnetic resonance device comprises a control unit and a cooling system. The control unit is configured to control the cooling system to operate in an emergency mode.

The cooling system may be configured to operate in an emergency mode in accordance with an embodiment described above. When operating in the emergency mode, the cooling system may be configured to provide a predetermined fraction of a nominal cooling capacity. According to an embodiment, the emergency mode may cause the cooling system to operate at a partial load or in a partial load range. Particularly, the cooling system may be configured to provide a predetermined fraction of a nominal cooling capacity when operating in the emergency mode. For example, the cooling system may be configured to provide a cooling capacity of less than 60 %, less than 50 %, less than 40 %, or less than 30 % of a maximum cooling capacity or nominal cooling capacity of the cooling system when operating in the emergency mode.

According to an embodiment, the cooling system may comprise a compressor. The control unit may be configured to control the compressor to operate at lower frequencies and/or lower speeds when operating in the emergency mode. However, the control unit may also be configured to control the cooling system, particularly the compressor, to operate in a pulsed mode. For example, the control unit may be configured to repeatedly activate and deactivate the cooling system and/or the compressor for predetermined periods of time. In other words, the cooling system and/or the compressor may operate at nominal capacity during active periods and provide no cooling capacity when deactivated or switched off. Thus, a mean cooling capacity of the cooling system operating in the emergency mode may depend on the distribution of active and inactive periods of the cooling system.

In a preferred embodiment, the cooling system comprises a cryocooler according to an embodiment described above. However, the cooling system may also comprise or consist of a water chiller configured to cool an examination room comprising the magnetic resonance device, but also a subsystem of the magnetic resonance device, such as a gradient system and/or a radio-frequency system.

In providing a magnetic resonance device comprising a cooling system configured to operate in an emergency mode, a power demand of the cooling system may favourably be adjusted in dependence of an amount of electrical energy and/or a maximum power provided via the conversion unit. Furthermore, an inventive magnetic resonance device may favourably allow for the electrical energy accumulated in the superconducting magnet to be used to cool the magnetic resonance device, particularly the cold mass of the magnetic resonance device. Thus, a heating of the cold mass associated with the release of heat energy via a conventional run-down load may favourably be reduced.

According to an embodiment of the inventive magnetic resonance device, the control unit is configured to limit an activity of a power-consuming component of the magnetic resonance device when the cooling system operates in the emergency mode.

As described above, the control unit may be configured to control the cooling system to operate in the emergency mode when the superconducting magnet is ramped down. For example, the control unit may be configured to provide a signal triggering a ramp-down of the superconducting magnet. The signal, or one or more furthers signals based on the signal, may control the cooling system to engage the emergency mode, and activate the switch causing the electrical energy accumulated in the superconducting magnet to be diverted to the conversion unit.

In a preferred embodiment, the control unit is configured to deactivate one or more components of the magnetic resonance during the ramp-down of the superconducting magnet, but also after the superconducting magnet has been ramped down or de-energized. For example, the control unit may be configured to deactivate the one or more components until the superconducting magnet is re-energized (e. g. until the supply of electrical energy to the superconducting magnet is resumed or completed, or the superconducting magnet provides a predetermined magnetic field). However, the control unit may also be configured to put the one or more components of the magnetic resonance device into a sleep mode or standby mode. The sleep mode or standby mode may be characterized by a significantly reduced energy consumption of the one or more components compared to a standard mode of operation.

According to an embodiment, the power-consuming component comprises at least one of a gradient system, a gradient amplifier, a radio-frequency system, a radio-frequency amplifier, or a secondary power supply.

In limiting an activity of one or more components of the magnet resonance device during a ramp-down of the superconducting magnet, any additional heating associated with the operation of such components can be avoided. Thus, a required cooling capacity of the cooling system in an emergency mode may favourably be reduced. Furthermore, a maximum duration of operation of the cooling system can favourably be extended.

Further advantages and details of the present invention may be recognized from the embodiments described below as well as the drawings. The figures show:
- Fig. 1: a schematic representation of an embodiment of an inventive magnetic resonance device,
- Fig. 2: a schematic representation of an embodiment of an inventive magnet arrangement,
- Fig. 3: a schematic representation of an embodiment of an inventive magnet arrangement,
- Fig. 4: a schematic representation of an embodiment of an inventive magnetic resonance device,
- Fig. 5: a schematic representation of an embodiment of an inventive electro-mechanical storage device.

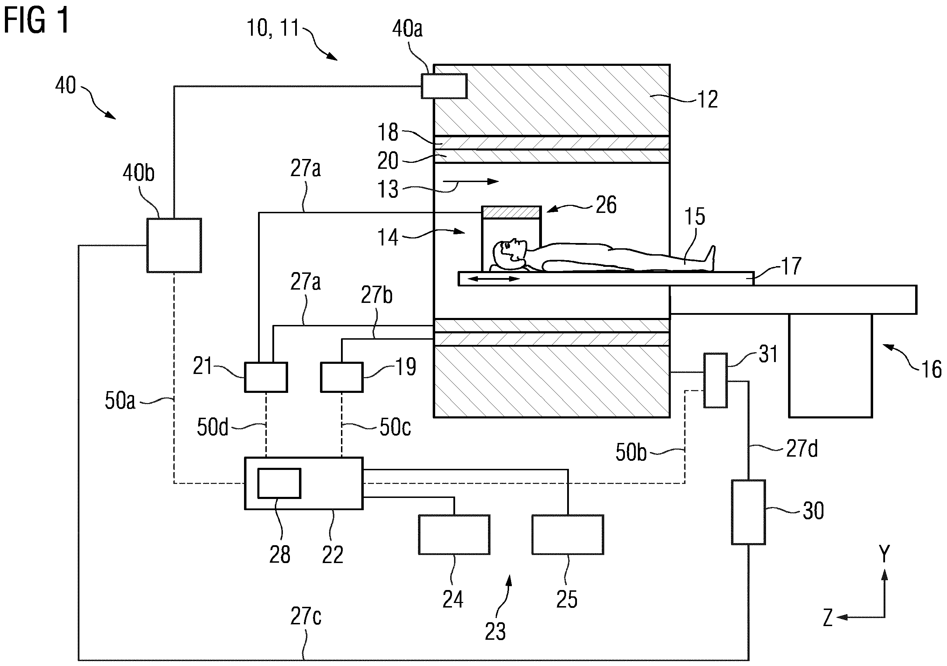

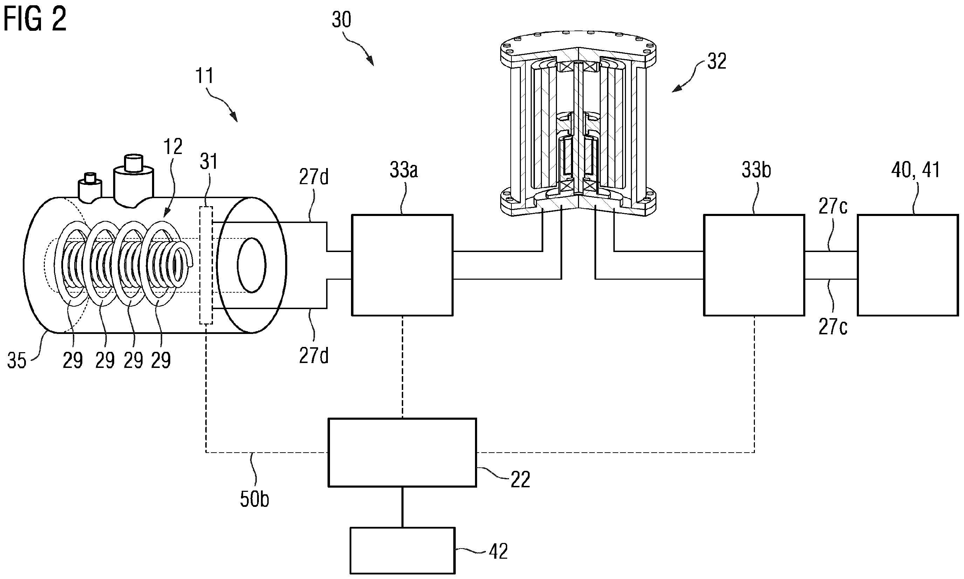

Fig. 1 shows an embodiment of a magnetic resonance device 10 according to the invention. In the illustrated example, the magnetic resonance device 10 comprises a static field magnet or main magnet 12 configured to provide a homogenous, static magnetic field 13 (80 field). The main magnet 12 comprises one or more superconducting magnets 29 or superconducting coils (see Figs. 2 to 4). The static magnetic field 13 permeates an imaging region 14 configured to receive an imaging object 15, such as a patient. The imaging region 14 may correspond to a patient bore configured to accommodate the patient 15 during a magnetic resonance measurement. The imaging region 14 is encompassed by the main magnet 12 in a circumferential direction. The main magnet 12 forms a part of the inventive magnet arrangement 11.

The magnetic resonance device 10 may comprise a patient positioning device 16 configured to transport the patient 15 into the imaging region 14. Particularly, the patient positioning device 16 may be configured to transport a diagnostically relevant body region of the patient 15 into the imaging volume or isocentre (not shown) of the magnetic resonance device 10. The main magnet 12 and other components of the magnetic resonance device 10 may be concealed in a housing.

The magnetic resonance device 10 may comprise a gradient system including one or more gradient coils 18. The one or more gradient coils 18 may be configured to generate magnetic field gradients in different, preferably orthogonally oriented, spatial directions. The magnetic field gradients can be used for spatial encoding of magnetic resonance signals or magnetic resonance data acquired during a magnetic resonance measurement. The one or more gradient coils 18 can be activated or controlled via an appropriate control signal provided by a gradient control unit 19 or gradient amplifier. For this purpose, the one or more gradient coils 18 may be electrically connected to the gradient control unit 19 via an electrical signal connection 27b.

The magnetic resonance device 10 may further comprise an integrated radio-frequency antenna 20 (i. e. a body coil). The radio-frequency antenna 20 may be activated or controlled via a radio-frequency control unit 21 or radio-frequency amplifier. The radio-frequency control unit 21 may be configured to control the radio-frequency antenna 20 to generate a high frequency magnetic field and emit radio-frequency excitation pulses into the imaging region 14.

Preferably, the magnetic resonance device 10 comprises a local coil 26. The local coil 26 may be positioned on or in proximity to the diagnostically relevant region of the patient 15 (e. g. the dental region as shown in Fig. 1). The local coil 26 may be configured to emit radio-frequency excitation pulses into the patient 15 and/or receive magnetic resonance signals from the patient 15. It is conceivable, that the local coil 26 is controlled via the radio-frequency controller 21. The radio-frequency antenna 20 and/or the local coil 26 may be electrically connected to the radio-frequency control unit 21 via the electrical signal connections 27a.

The magnetic resonance device 10 comprises a control unit 22 configured to control the magnetic resonance device 10. In the example depicted in Fig. 1, the control unit 22 comprises a processing unit 28 configured to process magnetic resonance signals and reconstruct magnetic resonance images. The processing unit 28 may also be configured to process input from a user of the magnetic resonance device 10 and/or provide an output to a user. For this purpose, the processing unit 28 and/or the control unit 22 can be connected to a display unit 24 and an input unit 25 via a suitable signal connection. For a preparation of a magnetic resonance measurement, preparatory information, such as imaging parameters or patient information, can be provided to the user via the display unit 24. The display unit 24 may comprise, for example, one or more screens or monitors. The display unit 24 may be configured to display control information, such as magnetic resonance imaging parameters, to the user. However, the display unit 24 may also be configured to provide a graphical user interface with a representation of a diagnostically relevant body region of patient 15. The input unit 25 may be configured to receive information and/or imaging parameters from the user.

The display unit 24 and the input unit 25 may form a part of a user interface 23. The user interface 23 may be connected to the control unit 22 via a suitable signal connection.

The magnet arrangement 11 of the magnetic resonance device 10 comprises a switch 31 electrically connected to the main magnet 12. The switch 31 is configured to interrupt a closed-circuit current in the main magnet 12 and divert electrical energy accumulated in the main magnet 12 to the conversion unit 30. The conversion unit 30 is configured to convert the electrical energy accumulated in the main magnet 12 to mechanical energy and to store the mechanical energy for a predetermined period of time.

In the embodiment depicted in Fig. 1, the switch 31 is controlled automatically by the control unit 22 of the magnetic resonance device 10 via the signal connection 50b. However, the switch 31 may also be controlled manually. For example, a user may initiate a manual ramp-down of the magnetic resonance device 10 via the input unit 25. It is also conceivable that the switch 31 is configured to be controlled via a mechanical interaction. The signal connections 50 depicted in Fig. 1 may be configured to enable a wired or wireless communication or signal transmission.

The conversion unit 30 is electrically connected to a cooling system 40 via the electrical signal connection 27c. Preferably, the conversion unit 30 comprises one or more flywheels, one or more gravity batteries and/or a compressed-air energy storage configured to convert the stored mechanical energy back into electrical energy. In the depicted example, the conversion unit 30 is configured to supply electrical energy to the cooling system 40 to extend or maintain operation of the cooling system 40 in the event of a power failure or blackout.

The cooling system 40 may include a cryocooler 40a and a compressor 40b configured to provide the cryocooler with pressurized cryogenic fluid. The cryocooler 40a may comprise a cold head (not shown) having one or more cooling stages thermally connected to the cold mass of the magnetic resonance device 10. Particularly, the cold mass of the magnetic resonance device 10 may be thermally connected to the one or more cooling stages via a solid thermal conductor, a heat pipe, or a fluid and/or a convection loop.

In one embodiment, the control unit 22 is configured to control the cooling system 40 to operate in an emergency mode. For example, the control unit 22 may be configured to control the cooling system 40 to operate in the emergency mode by providing a control signal via the signal connection 50a.

In a further embodiment, the control unit 22 is configured to limit an activity of a power-consuming component of the magnetic resonance device 10 when the cooling system 40 operates in the emergency mode. In the example depicted in Fig. 1, the control unit 22 is configured to deactivate the gradient control unit 19 and/or radio-frequency control unit 18 by providing a control signal via the signal connections 50c and 50d.

In a preferred embodiment, the control unit 22 is configured to control the cooling system 40 to operate in the emergency mode, activate the switch 31 to divert the electrical energy accumulated in the main magnet 12 to the conversion unit 30 and deactivate the gradient control unit 19 and the radio-frequency control unit 18, when a power failure is detected and/or a ramp-down of the main magnet 12 is initiated (e. g. manually or automatically).

Of course, the magnetic resonance device 10 may comprise further components and/or functions which are common in magnetic resonance devices. The general operation of a magnetic resonance device 10 is known to those skilled in the art, so a more detailed description is omitted.

Fig. 2 shows a schematic representation of an embodiment of an inventive magnet arrangement 11. As described with respect to Fig. 1, the magnet arrangement 11 may comprise a switch 31 configured to interrupt a closed-circuit current in the main magnet 12 and divert electrical energy accumulated in the main magnet 12 to the conversion unit 30 in response to a control signal provided by the control unit 22 via the signal connection 50b.

The switch 31 may be embodied as a thermal switch. The control unit 22 may be configured to control a heater (not shown) configured to heat the thermal switch, particularly a superconducting element of the thermal switch. In response to being heated, the superconducting element may lose its superconducting properties and interrupt the closed-circuit current flow through the superconducting coils 29 of the main magnet 12, thus diverting the current flow to an input of a conditioning unit 33a.

Preferably, the main magnet 12 and the switch 31 are arranged in a vacuum region enclosed by an outer vacuum chamber 35 of the magnetic resonance device 11. Other parts of the magnet arrangement 11, such as the conversion unit 30 comprising the conditioning units 33a and 33b and the electro-mechanical storage device 32, may be arranged outside the outer vacuum chamber 35. The components of the conversion unit 30 arranged outside the outer vacuum chamber 35 may be electrically connected to the switch 31 and the main magnet 12 via an electrical signal connection 27d which is routed through a wall of the outer vacuum chamber 35 via a fluid-tight (or vacuum-tight) feed-through or cable entry (not shown).

In the depicted example, the conversion unit 30 comprises an electro-mechanical storage device 32, particularly a flywheel, configured to receive and store the electrical energy from the superconducting magnet 12 in form of mechanical energy. The electro-mechanical storage device 32 comprises a conditioning unit 33a configured to divert the electrical energy accumulated in the main magnet 12 to the electro-mechanical storage device 32 at a predetermined voltage and at a substantially constant current decay rate. In a preferred embodiment, the conditioning unit 33a may comprises or consist of an inverter.

According to an embodiment, the conversion unit 30 comprises a second conditioning unit 33b electrically connected to the cooling system 40 and/or a power grid 41. The conditioning unit 33b may be configured to condition a property of electrical energy provided by the electro-mechanical storage device 32 in dependence of a requirement of a connected cooling system 40 or power grid 41. The power grid 41 may represent an electrical utility network or an electrical island. According to an embodiment, the electrical island is an electrical network or a part of a power grid which is insulated or electrically separated from a main grid at least during a ramp-down process of the superconducting magnet 12. Preferably, the electrical island comprises the cooling system 40 or a dedicated cooling system.

In the example depicted in Fig. 2, the magnetic resonance device 10 comprises an uninterruptible power supply 42 electrically connected to the control unit 22. The uninterruptible power supply 42 is configured to provide electrical energy to the control unit 22, but also other components of the magnetic resonance device 10, in the event of a power failure. In some embodiments, the uninterruptible power supply 42 comprises or consists of an electric battery, a Diesel generator, a fuel cell and/or a cogeneration unit.

Preferably, the uninterruptible power supply 42 is configured to maintain a supply of electrical energy to the control unit 22 in the event of a power failure. Thus, the control unit 22 may initiate a controlled ramp-down of the magnetic resonance device 10 and control the switch 31 to interrupt the closed-circuit current in the main magnet 12 to divert electrical energy accumulated in the main magnet 12 to the conversion unit 30.

The process of ramping down the main magnet 12 may be completed, when the entire electrical energy in the main magnet 12 has been discharged and stored within the flywheel 32. After the electrical energy in the main magnet 12 has been discharged, the inverter 33a may be deactivated via the control unit 22. The control unit 22 may control the inverter 33b to begin extracting energy stored within the flywheel 32 after the electrical energy in the main magnet 12 has been discharged.

A superconducting magnet 29 of a main magnet 12 of a magnetic resonance device 11 may represent a large inductance that stores a finite amount of magnetic energy. In the embodiment depicted in Fig. 2, the energy extracted from the main magnet 12 (or the plurality of superconducting magnets 29) is stored as kinetic energy in the flywheel 32. The flywheel 32 is configured to absorb energy from the main magnet 12 and to release the energy on demand.

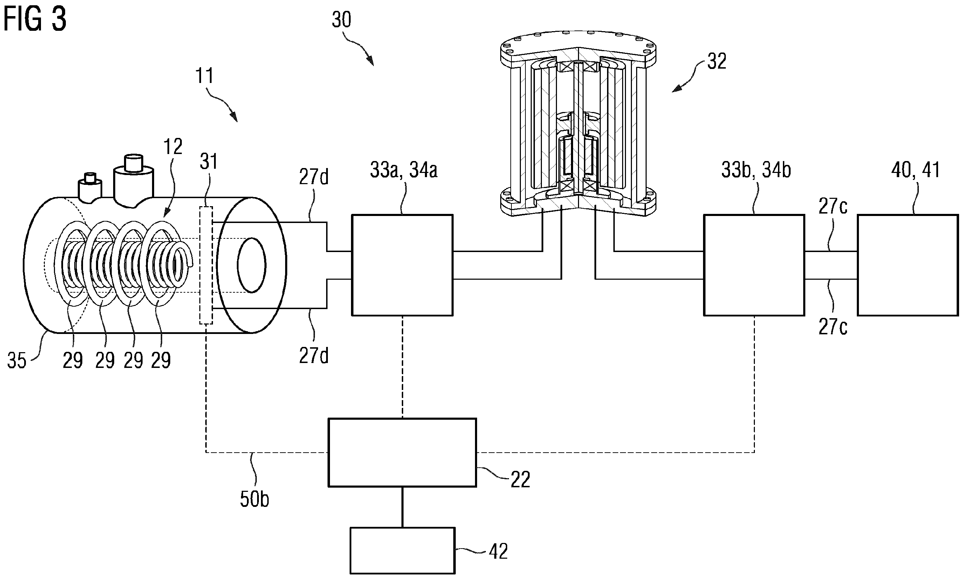

Fig. 3 illustrates a further embodiment of an inventive magnet arrangement 11. In the depicted example, the magnet arrangement 11 comprises an electrical energy storage 34a configured to store the electrical energy accumulated in the main magnet 12. The electrical energy storage 34a may comprise a conditioning unit 33a according to an embodiment described above. Preferably, the electrical energy storage 34a is configured to receive electrical energy accumulated in the main magnet 12 and transfer the electrical energy to the electro-mechanical storage device 32. Preferably, the electrical energy storage 34a is configured to condition the electrical energy supplied to the electro-mechanical storage device 32 in accordance with an embodiment described above.

According to an embodiment of the inventive magnet arrangement 11, the conditioning unit 33b depicted in Fig. 2 is replaced by an electrical energy storage 34b. The electrical energy storage 34b may comprise a conditioning unit 33b according to an embodiment described above. Particularly, the electrical energy storage 34b may be configured to receive and store electrical energy provided by the electro-mechanical storage device 32 and supply the electrical energy to a cooling system 40 or power grid 41 in accordance with an embodiment described above.

Preferably, the electrical energy storage 34 comprises or consists of one or more electric batteries and/or one or more supercapacitors.

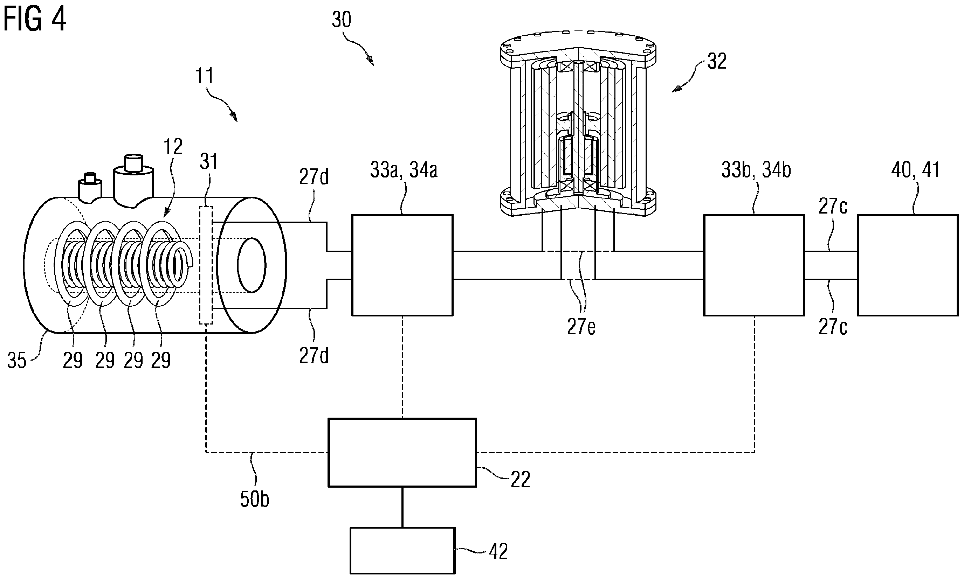

Fig. 4 shows a version of an embodiment of an inventive magnet arrangement 11 illustrated in Fig. 2 and Fig. 3. In the example depicted in Fig. 4, the conditioning unit 33a or electrical storage device 34a is connected to the conditioning unit 33b or electrical storage device 34b and/or the cooling system 40 or the power grid 41 via the electrical signal connection 27e. Particularly, the conversion unit 31 may comprise a switch (not shown) configured to bypass the electro-mechanical energy storage device 32 in such a way, that electrical energy can be transmitted from the conditioning unit 33a or electrical storage device 34a to the conditioning unit 33b or electrical storage device 34b via the electrical signal connection 27e. It is also conceivable, that the switch is configured to bypass the electro-mechanical energy storage device 32 and the conditioning unit 33b or electrical storage device 34b in such a way, that electrical energy can be transmitted from the conditioning unit 33a or electrical storage device 34a to the cooling system 40 or power grid 41. Thus, the electrical energy discharged from the main magnet 12 may be directly supplied to a cooling system 40 and/or power grid 41 in case the electro-mechanical storage device 32 is inoperable or defective.

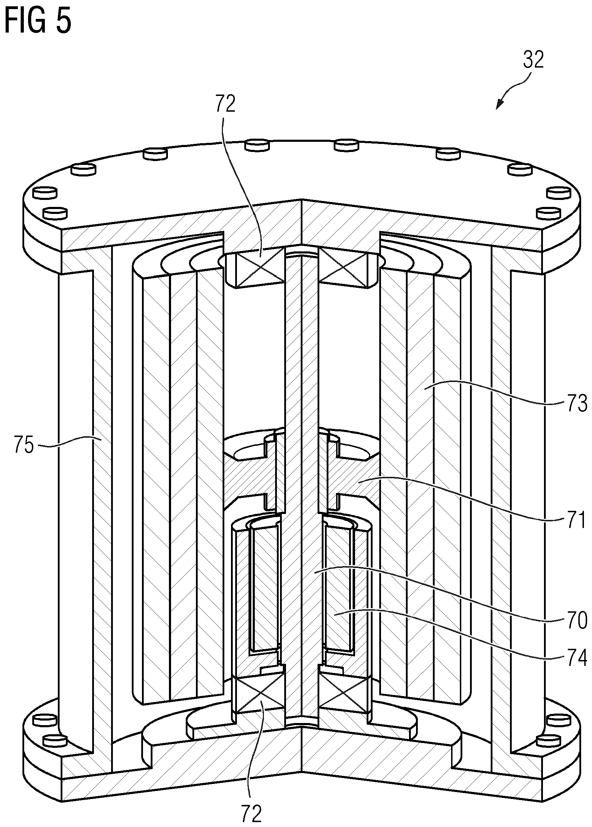

Fig. 5 shows an embodiment of an electro-mechanical storage device 32. In the depicted example, the electro-mechanical energy storage device 32 is configured as a flywheel comprising a central shaft 70, a hub 71, magnetic bearings 72, a rotor 73 and a motor/generator 74 enclosed in a vacuum enclosure 75.

The motor/generator 74 is configured to accelerate the cylindrical rotor 73 when supplied with electrical energy from the main magnet 12, the conditioning unit 33a, or the electrical energy storage 34a via a suitable electrical signal connection (not shown). Thus, the electrical energy is converted into kinetic energy defined by the rotational motion of the rotor 73. In order to extract electrical energy from the flywheel 32, the rotor 73 may drive the motor/generator 74 which converts the kinetic energy of the rotor 73 into electrical energy. The electrical energy may be transferred to the conditioning unit 33b, the electrical energy storage 34b, or the power grid 41 via a suitable electrical signal connection (not shown).

The embodiments described herein are to be recognized as examples. It is to be understood that individual embodiments may be extended by or combined with features of other embodiments if not explicitly stated otherwise. The embodiments depicted in the Figs. 1 to 9 are representations that do not necessarily have to be to scale.

## Claims

1. A magnet arrangement (11) for a magnetic resonance device (10), comprising a superconducting magnet (12; 29), a conversion unit (30), and a switch (31), wherein the switch (31) is configured to interrupt a closed-circuit current in the superconducting magnet (12; 29) and divert electrical energy accumulated in the superconducting magnet (12; 29) to the conversion unit (30), and wherein the conversion unit (30) is configured to convert the electrical energy accumulated in the superconducting magnet (12; 29) to mechanical energy and to store the mechanical energy for a predetermined period of time.

2. The magnet arrangement (11) according to claim 1, wherein the conversion unit (30) is configured to convert the stored mechanical energy to electrical energy.

3. The magnet arrangement (11) according to claim 2, wherein the conversion unit (30) is electrically connected to a cooling system (40), and wherein the conversion unit (30) is configured to power the cooling system (40) using the stored mechanical energy.

4. The magnet arrangement (11) according to one of the preceding claims, wherein the conversion unit (30) comprises an electro-mechanical storage device (32) configured to
• absorb and store the electrical energy accumulated in the superconducting magnet (12; 29) in form of mechanical energy, and
• convert the mechanical energy to electrical energy and release the electrical energy on demand.

5. The magnet arrangement (11) according to claim 4, wherein the electro-mechanical storage device (32) comprises at least one of a flywheel, a gravity battery, or a compressed-air storage.

6. The magnet arrangement (11) according to one of the claims 4 or 5, wherein the conversion unit (30) comprises a conditioning unit (33) configured to
• discharge the electrical energy accumulated in the superconducting magnet (12; 29) at a substantially constant current decay rate, and
• provide electrical energy to the electro-mechanical storage device (32) at a predetermined voltage.

7. The magnet arrangement (11) according to one of the claims 4 to 6, wherein the conversion unit (30) comprises a further conditioning unit (33) electrically connected to a power grid (41) and configured to condition a property of the electrical energy provided by the electro-mechanical storage device (32) in dependence of a requirement of the power grid (41).

8. The magnet arrangement (11) according to claim 7, wherein the power grid (41) represents
• an electrical utility network providing power to the magnet arrangement (11) and/or a cooling system (40) cooling the magnet arrangement (11), or
• an electrical island electrically insulated from the electrical utility network at least during a ramp-down of the superconducting magnet (12; 29).

9. The magnet arrangement (11) according to one of the preceding claims, comprising an electrical energy storage (34) electrically connected to the conversion unit (30).

10. A magnetic resonance device (10) configured to perform a magnetic resonance measurement of an object (15) positioned within an imaging region (14) of the magnetic resonance device (10), comprising a magnet arrangement (11) according to one of the preceding claims.

11. The magnetic resonance device (10) according to claim 10, comprising a control unit (22) and an uninterruptible power supply (42), wherein the control unit (22) is electrically connected to the uninterruptible power supply (42), and wherein the control unit (22) is configured to
• initiate a controlled ramp-down of the magnetic resonance device (10), and
• control the switch (31) to interrupt the closed-circuit current in the superconducting magnet (12; 29) and divert electrical energy accumulated in the superconducting magnet (12) to the conversion unit (30).

12. The magnetic resonance device (10) according to one of the claims 10 or 11, comprising a control unit (22) and a cooling system (40), wherein the control unit (22) is configured to control the cooling system (40) to operate in an emergency mode.

13. The magnetic resonance device (10) according to claim 12, wherein the control unit (22) is configured to limit an activity of a power-consuming component of the magnetic resonance device (10) when the cooling system (40) operates in the emergency mode.

14. The magnetic resonance device (10) according to claim 13, wherein the power-consuming component comprises at least one of a gradient control unit (19), a gradient amplifier, a radio-frequency control unit (18), a radio-frequency amplifier, or a secondary power supply.
